# EUROPEAN PATENT APPLICATION

(11) **EP 3 139 422 A2**
(43) Date of publication of application: **08.03.2017**
(21) Application number: 16186447.5
(22) Date of filing: 30.08.2016
(51) Int. Cl.: H01L 51/52, H01L 27/32

(54) **TRANSPARENT DISPLAY DEVICES AND METHOD OF MANUFACTURING THE SAME**

(30) Priority: 04.09.2015 KR 20150125259
(71) Applicant: Samsung Display Co., Ltd., Gyeonggi-do 17113 (KR)
(72) Inventor: YIM, Sang-Hoon, Gyeonggi-Do (KR); KIM, Dong-Chan, Gyeonggi-do (KR); KIM, Won-Jong, Gyeonggi-Do (KR); KIM, Eung-Do, Seoul (KR); SEO, Dong-Kyu, Gyeonggi-do (KR); LEE, Ji-Hye, Incheon (KR); IM, Da-Hea, Incheon (KR); CHO, Yoon-Hyeung, Gyeonggi-do (KR); CHU, Chang-Woong, Gyeonggi-do (KR); HAN, Won-Suk, Gyeonggi-do (KR)
(74) Representative: Taor, Simon Edward William

(57) **Abstract**

**Transparent Display Devices and Method of Manufacturing the Same**

A transparent display device includes a substrate having a pixel area (PA) and a transmission area (TA), a pixel circuit in the pixel area of the substrate, an insulation structure (160) covering the pixel circuit on the substrate, a first (170) electrode in the pixel area of the substrate and extending at least partially through the insulation structure to be electrically connected to the pixel circuit, a display layer (200) on the first electrode, a second electrode (210) facing the first electrode with respect to the display layer, and a capping layer (220) on the second electrode. The capping layer (220) continuously extends into the pixel area (PA) and the transmission area (TA). The capping layer (220) has a thickness in a range from about 35 nm (350 Å) to about 70 nm (700 Å).

## Description

This disclosure relates to transparent display devices and methods of manufacturing the same. More particularly, the present disclosure relates to transparent display devices including a transmission area and a pixel area, and methods of manufacturing the same.

Recently, display devices such as organic light emitting display (OLED) device having transparent or transmitting properties have been developed.

Various parameters including a composition, an arrangement or a thickness of a substrate, an electrode, an insulation layer, a capping layer, etc., may be controlled so as to obtain a transparent display device. The OLED device may include a plurality of insulation layers and conductive layers which may be formed of different materials, and thus the transmitting property may not be easily realized.

Example embodiments provide a transparent display device having an improved transmittance.

Example embodiments provide a method of manufacturing a transparent display device having an improved transmittance.

According to example embodiments, there is provided a transparent display device. The transparent display device may include a substrate having a pixel area and a transmission area, a pixel circuit in the pixel area of the substrate, an insulation structure covering the pixel circuit on the substrate, a first electrode in the pixel area of the substrate and extending at least partially through the insulation structure to be electrically connected to the pixel circuit, a display layer on the first electrode, a second electrode facing the first electrode with respect to the display layer, and a capping layer on the second electrode. The capping layer may extend continuously into the pixel area and the transmission area. The capping layer may have a thickness in a range from about 35 nm (350 Å) to about 70 nm (700 Å).

In example embodiments, the second electrode may continuously extend into the pixel area and the transmission area.

In example embodiments, the second electrode may include silver (Ag), magnesium (Mg), or an alloy of Ag and Mg.

In example embodiments, the second electrode may have a thickness in a range from about 3 nm (30 Å) to about 12 nm (120 Å).

In example embodiments, the display layer may include an organic light emitting layer. The first electrode and the second electrode may serve as an anode and a cathode, respectively. The capping layer may include a hole transport-type organic material.

In example embodiments, the transparent display device may further include a pixel defining layer on the insulation structure. A transmitting window exposing the insulation structure at the transmission area may be defined by a top surface of the insulation structure and a sidewall of the pixel defining layer.

In example embodiments, the pixel circuit may include an active pattern, a gate electrode, a source electrode and a drain electrode on the substrate. The insulation structure may include a gate insulation layer covering the active pattern on the substrate, an insulating interlayer covering the gate electrode on the gate insulation layer, and a via insulation layer covering the source electrode and the drain electrode on the insulating interlayer. The source electrode and the drain electrode may extend through the insulating interlayer and the gate insulation layer to be in contact with the active pattern. The first electrode may extend through the via insulation layer to be in contact with the drain electrode.

In example embodiments, the via insulation layer may be selectively formed in the pixel area, and a transmitting window may be defined at the transmission area by a sidewall of the via insulation layer and a top surface of the insulating interlayer.

In example embodiments, the second electrode and the capping layer may be formed along a surface of the transmitting window at the transmission area.

In example embodiments, the via insulation layer and the insulating interlayer may be selectively disposed in the pixel area, and a transmitting window may be defined at the transmission area by a sidewall of the via insulation layer and a top surface of the gate insulation layer.

In example embodiments, the transparent display device may further include a filling layer and an encapsulation substrate sequentially disposed on the capping layer.

In example embodiments, the capping layer may include an organic material having a refractive index of at least about 1.85.

In example embodiments, the filling layer may include an organic material having a refractive index in a range from about 1.4 to about 1.6.

According to example embodiments, there is provided a transparent display device. The transparent display device may include a substrate having a pixel area and a transmission area, a pixel circuit at the pixel area of the substrate, an insulation structure covering the pixel circuit on the substrate, a first electrode at the pixel area of the substrate and extending at least partially through the insulation structure to be electrically connected to the pixel circuit, a display layer on the first electrode, a second electrode facing the first electrode with respect to the display layer, and a capping layer on the second electrode. The capping layer may continuously extend into the pixel area and the transmission area. The capping layer may have different thicknesses at the pixel area and the transmission area.

In example embodiments, the capping layer may include a first portion covering the pixel area and having a thickness in a range from about 70 nm (700 Å) to about 90 nm (900 Å), and a second portion covering the transmission area and having a thickness in a range from about 35 nm (350 Å) to about 70 nm (700 Å).

In example embodiments, the second electrode may continuously extend into the pixel area and the transmission area.

In example embodiments, the second electrode may include Ag, Mg, or an alloy of Ag and Mg, and the second electrode may have a thickness in a range from about 3 nm (30 Å) to about 12 nm (120 Å).

In example embodiments, a thickness of the insulation structure at the transmission area may be less than a thickness of the insulation structure at the pixel area, and a transmitting window may be defined by a surface of the insulation structure at the transmission area. The second electrode and the capping layer may be formed along a surface of the transmitting window at the transmission area.

According to example embodiments, there is provided a method of manufacturing a transparent display device. In the method, a substrate having a pixel area and a transmission area may be prepared. A pixel circuit may be formed on the substrate. An insulation structure may be formed on the substrate. The insulation structure may at least partially cover the pixel circuit. A first electrode may be formed on a portion of the insulation structure at the pixel area. The first electrode may be electrically connected to the pixel circuit. A display layer may be formed on the first electrode. A second electrode may be formed on the display layer. The second electrode may face the first electrode. A maximum transmittance thickness and a maximum luminescent efficiency thickness of a capping layer may be determined under a thickness condition of the second electrode. The capping layer may be formed on the second electrode. The capping layer may have the maximum luminescent efficiency thickness at the pixel area and the maximum transmittance thickness at the transmittance area.

In example embodiments, the maximum luminescent efficiency thickness may correspond to a minimum transmittance thickness.

According to an aspect of the invention, there is provided a transparent display device as set out in claim 1. Preferred features are set out in claims 2 to 9.

According to an aspect of the invention, there is provided a transparent display device as set out in claim 10. Preferred features are set out in claims 11 to 13.

According to an aspect of the invention, there is provided a method as set out in claim 15. Preferred features are set out in claim 15.

Example embodiments will be more clearly understood from the following detailed description taken in conjunction with the accompanying drawings. FIGS. 1 to 29 represent non-limiting, example embodiments as described herein:
FIGS. 1 and 2 are schematic top plan views illustrating a transparent display device in accordance with example embodiments;
FIGS. 3 and 4 are cross-sectional views illustrating transparent display devices in accordance with example embodiments;
FIGS. 5 to 11 are cross-sectional views illustrating a method of manufacturing a transparent display device in accordance with example embodiments;
FIGS. 12 and 13 are cross-sectional views illustrating a method of manufacturing a transparent display device in accordance with example embodiments;
FIGS. 14 and 15 are cross-sectional views illustrating transparent display devices in accordance with some example embodiments;
FIGS. 16 and 17 are cross-sectional views illustrating transparent display devices in accordance with some example embodiments;
FIGS. 18 to 20 are cross-sectional views illustrating a method of manufacturing a transparent display device in accordance with some example embodiments;
FIGS. 21 and 22 are cross-sectional views illustrating transparent display devices in accordance with some example embodiments;
FIGS. 23 to 27 are cross-sectional views illustrating a method of manufacturing a transparent display device in accordance with some example embodiments; and
FIGS. 28 and 29 are graphs showing a transmittance change in relation to a thickness change of a capping layer.

Various example embodiments will be described more fully hereinafter with reference to the accompanying drawings, in which some example embodiments are shown. The present inventive concept may, however, be embodied in many different forms and should not be construed as limited to the example embodiments set forth herein. Rather, these example embodiments are provided so that this disclosure will be thorough and complete, and will fully convey the scope of the present inventive concept to those skilled in the art. In the drawings, the sizes and relative sizes of layers and regions may be exaggerated for clarity. Like numerals refer to like elements throughout.

It will be understood that, although the terms first, second, third etc. may be used herein to describe various elements, these elements should not be limited by these terms. These terms are used to distinguish one element from another. Thus, a first element discussed below could be termed a second element without departing from the teachings of the present inventive concept. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular example embodiments only and is not intended to be limiting of the present inventive concept. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

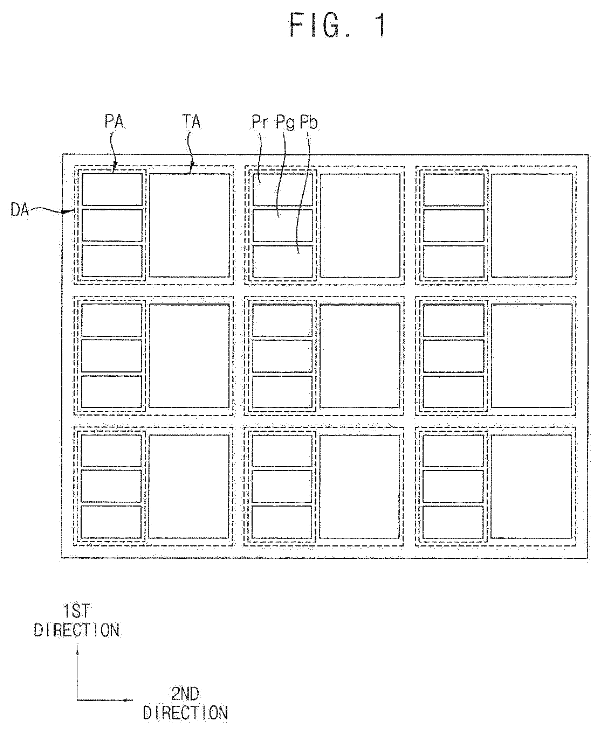

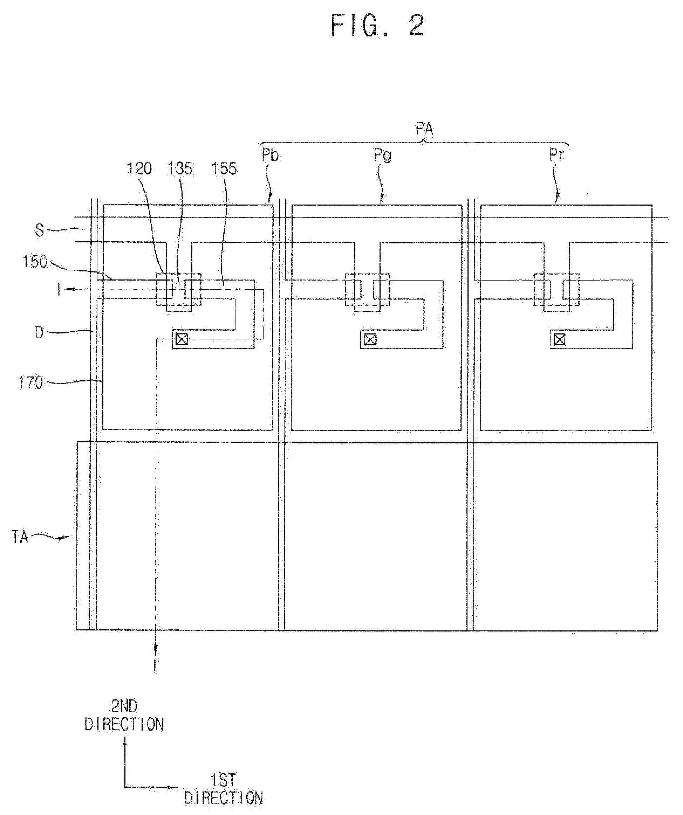

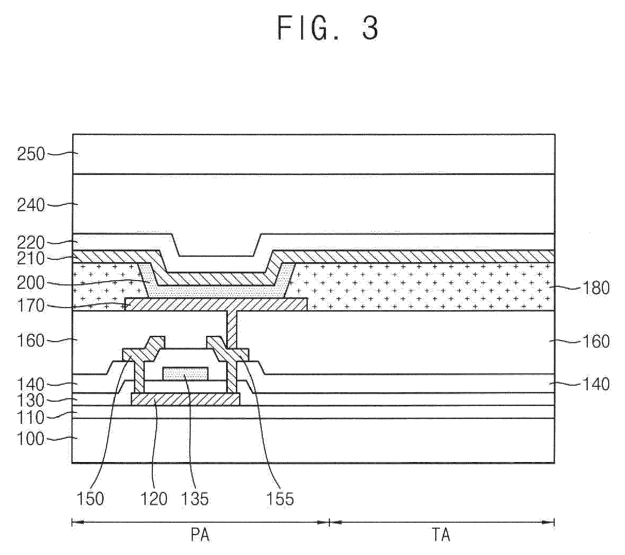

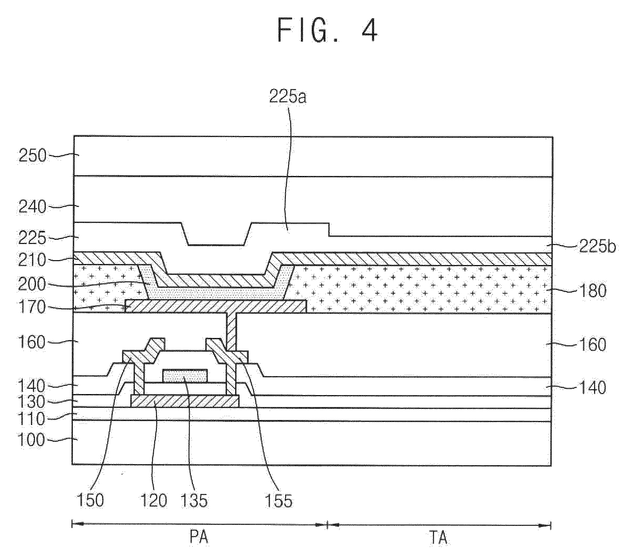

FIGS. 1 and 2 are schematic top plan views illustrating a transparent display device in accordance with example embodiments. FIGS. 3 and 4 are cross-sectional views illustrating transparent display devices in accordance with example embodiments.

For example, FIG. 2 is an enlarged top plan view of one of display areas DA indicated in FIG. 1. FIGS. 3 and 4 are cross-sectional views taken along a line I-I' indicated in FIG. 2.

Referring to FIGS. 1 and 2, the transparent display devices may include a plurality of the display areas DA. The display areas DA may be arranged along a first direction and a second direction which may be parallel to a top surface of a substrate 100 (see FIGS. 3 and 4) and may be perpendicular to each other.

Each display area DA may include a pixel area (PA) and a transmission area (TA). A plurality of pixels may be arranged along, e.g., the first direction and may be adjacent to each other in the pixel area PA. For example, each pixel area PA may include a red pixel Pr, a green pixel Pg and a blue pixel Pb.

Pixels Pr, Pg and Pb may have substantially the same dimensions as what is illustrated in FIGS. 1 and 2. However, the red pixel Pr, the green pixel Pg and the blue pixel Pb may have different dimensions from each other for improving a luminescent efficiency.

The transmission area TA may be adjacent to the red pixel Pr, the green pixel Pg and the blue pixel Pb in the display area DA. In some embodiments, the transmission area TA may be independently patterned per each pixel of the pixel area PA.

In some embodiments, the transmission area TA may extend in, e.g., the first direction, and may be provided commonly for the pixel areas PA included in a plurality of the display areas DA.

In example embodiments, a pixel circuit for implementing an image may be disposed in the pixel area PA. An external light may be transmitted at the transmission area TA so that an external image may be observed.

A transistor such as a thin film transistor (TFT) may be disposed in each pixel of the pixel area PA, and the transistor may be electrically connected to a data line D and a scan line S. As illustrated in FIG. 2, the data line D and the scan line S may cross each other, each pixel may be defined at an intersection region of the data line D and the scan line S. The pixel circuit may include the data line D, the scan line S and the transistor.

The pixel circuit may further include a power line Vdd (not illustrated) that may be parallel to the data line D. A capacitor electrically connected to the power line Vdd and the transistor may be provided in the each pixel.

One transistor is illustrated in each pixel in FIG. 2; however, at least two transistors may be provided per each pixel in other embodiments. For example, a switching transistor and a driving transistor may be provided in the each pixel. The capacitor may be connected between the switching transistor and the driving transistor.

Referring to FIG. 3, the transistor may be disposed on a portion of a barrier layer 110 formed on the substrate 100 at the pixel area PA. The transistor may include an active pattern 120, a gate insulation layer 130, a gate electrode 135, a source electrode 150 and a drain electrode 155. A via insulation layer 160 may cover the transistor, and a first electrode 170 electrically connected to the drain electrode 155 may be disposed on the via insulation layer 160.

A transparent insulation substrate may be utilized as the substrate 100. For example, the substrate 100 may include glass, or a polymeric material having transparent and flexible properties. If the substrate 100 includes the polymeric material, the transparent display device may be provided as a transparent flexible display device. For example, the substrate 100 may include polyimide, polysiloxane, an epoxy-based resin, an acryl-based resin, polyester, or the like. In an embodiment, the substrate 100 may include polyimide.

According to a construction of the transparent display device illustrated in FIGS. 1 and 2, the substrate 100 may also include the pixel area PA and the transmission area TA.

The barrier layer 110 may be formed on a top surface of the substrate 100. In some embodiments, the barrier layer 110 may be commonly formed on the pixel area PA and the transmission area TA of the substrate 100. Moisture and/or impurity diffusion through the substrate 100, and between the substrate 100 and a structure thereon may be blocked by the barrier layer 110.

For example, the barrier layer 110 may include silicon oxide, silicon nitride or silicon oxynitride. These may be used alone or in a combination. In some embodiments, the barrier layer 110 may have a multi-layered structure including a silicon oxide layer and a silicon nitride layer.

The active pattern 120 may be disposed on a portion of the barrier layer 110 on the pixel area PA.

The active pattern 120 may include a silicon compound such as polysilicon. In some embodiments, a source region and a drain region including p-type or n-type impurities may be formed at both ends of the active pattern 120.

In some embodiments, the active pattern 120 may include an oxide semiconductor, e.g., indium gallium zinc oxide (IGZO), zinc tin oxide (ZTO), indium tin zinc oxide (ITZO), or the like.

The gate insulation layer 130 may be formed on the barrier layer 110, and may cover the active pattern 120. In example embodiments, the gate insulation layer 130 may include silicon oxide, silicon nitride and/or silicon oxynitride. In some embodiments, the gate insulation layer 130 may have a multi-layered structure including a silicon oxide layer and a silicon nitride layer.

As illustrated in FIG. 3, the gate insulation layer 130 may commonly extend on the pixel area PA and the transmission area TA similarly to the barrier layer 110. In some embodiments, the gate insulation layer 130 may be substantially selectively disposed on the pixel area PA.

The gate electrode 135 may be disposed on the gate insulation layer 130. The gate electrode 135 may be substantially superimposed over the active pattern 120 with respect to the gate insulation layer 130.

The gate electrode 135 may be electrically connected to the scan line S. For example, as illustrated in FIG. 2, the gate electrode 135 may be diverged from the scan line S.

The gate electrode 135 may include a metal such as aluminum (Al), magnesium (Mg), silver (Ag), tungsten (W), copper (Cu), nickel (Ni), chromium (Cr), molybdenum (Mo), titanium (Ti), platinum (Pt), tantalum (Ta), neodymium (Nd) and scandium (Sc), an alloy thereof, or a nitride thereof. These may be used alone or in a combination. The gate electrode 135 may include at least two metal layers having different physical and chemical properties. For example, the gate electrode 135 may have a double-layered structure such as an Al/Mo structure or a Ti/Cu structure.

An insulating interlayer 140 may be formed on the gate insulation layer 130, and may cover the gate electrode 135. The insulating interlayer 140 may include silicon oxide, silicon nitride and/or silicon oxynitride. These may be used alone or in combination. The insulating interlayer 140 may have a multi-layered structure including a silicon oxide layer and a silicon nitride layer.

As illustrated in FIG. 3, the insulating interlayer 140 may commonly extend on the pixel area PA and the transmission area TA similarly to the barrier layer 110. In some embodiments, the insulating interlayer 140 may be substantially selectively disposed on the pixel area PA.

The source electrode 150 and the drain electrode 155 may extend through the insulating interlayer 140 and the gate insulation layer 130 to be in contact with the active pattern 120. The source electrode 150 and the drain electrode 155 may include a metal such as Al, Mg, Ag, W, Cu, Ni, Cr, Mo, Ti, Pt, Ta, Nd, or Sc, an alloy thereof, or a nitride thereof. These may be used alone or in combination. The source electrode 150 and the drain electrode 155 may include at least two different metal layers such as an Al layer and a Mo layer.

The source electrode 150 and the drain electrode 155 may be in contact with the source region and the drain region, respectively, of the active pattern 120. A portion of the active pattern 120 between the source region and the drain region may serve as a channel through which charges may be moved or transferred.

As illustrated in FIG. 2, the source electrode 150 may be electrically connected to the data line D. For example, the source electrode 150 may diverge from the data line D.

The transistor may be defined by the active pattern 120, the gate insulation layer 130, the gate electrode 135, the source electrode 150 and the drain electrode 155.

FIG. 3 illustrates that the transistor has a top gate structure in which the gate electrode 135 overlies the active pattern 120. However, the transistor may have a bottom gate structure in which the gate electrode 135 is disposed under the active pattern 120.

The via insulation layer 160 may be formed on the insulating interlayer 140, and may cover the source electrode 150 and the drain electrode 155. A via structure electrically connecting the first electrode 170 and the drain electrode 155 to each other may be accommodated in the via insulation layer 160. The via insulation layer 160 may have a substantially planar or leveled top surface, and may serve as a planarization layer of the transparent display device.

The via insulation layer 160 may include an organic material, e.g., polyimide, an epoxy-based resin, an acryl-based resin, polyester, or the like. In example embodiments, the via insulation layer 160 may commonly extend on the pixel area PA and the transmission area TA.

The first electrode 170 may be disposed on the via insulation layer 160, and may include the via structure extending through the via insulation layer 160 to be in contact with or electrically connected to the drain electrode 155. The first electrode 170 may be selectively disposed on the pixel area PA, and may be individually provided per each pixel. The first electrode 170 may serve as a pixel electrode or an anode.

In an embodiment, the first electrode 170 may include a transparent conductive material having a high work function. For example, the first electrode 170 may include indium tin oxide (ITO), indium zinc oxide (IZO), zinc oxide, or indium oxide. In this case, a transmittance of the transparent display device may be further improved.

In an embodiment, the first electrode 170 may serve as a reflective electrode. In this case, the first electrode 170 may include a metal, e.g., Al, Mg, Ag, W, Cu, Ni, Cr, Mo, Ti, Pt, Ta, Nd or Sc, or an alloy thereof.

In an embodiment, the first electrode 170 may have a multi-layered structure including the transparent conductive material and the metal.

A back-plane (BP) structure of the transparent display device which may include the pixel circuit, the insulation layers and the first electrode 170 may be defined.

The BP structure may further include a pixel defining layer (PDL) 180. The PDL 180 may be formed on the via insulation layer 160, and may cover a peripheral portion of the first electrode 170. The PDL 180 may include a transparent organic material such as polyimide or an acryl-based resin.

Each pixel of the pixel area PA may be exposed by the PDL 180. An area of the first electrode 170 that is not be covered by the PDL 180 may be substantially equal to a light emitting area of the respective pixel.

In example embodiments, the PDL 180 may also extend to the transmission area TA.

A display layer 200 may be disposed on the PDL 180 and the first electrode 170. For example, the display layer 200 may be disposed on a sidewall of the PDL 180 and a top surface of the first electrode 170 exposed by the PDL 180.

The display layer 200 may include an organic light emitting layer patterned individually for the red pixel Pr, the green pixel Pg and the blue pixel Pb to generate a different color at each pixel. The organic light emitting layer may include a host material excited by holes and electrons, and a dopant material improving an emitting efficiency by absorbing and releasing energy.

In some embodiments, the display layer 200 may further include a hole transport layer (HTL) between the first electrode 170 and the organic light emitting layer. The display layer 200 may further include an electron transport layer (ETL) on the organic light emitting layer.

The HTL may include a hole transport material, e.g., 4,4'-bis[N-(1-naphtyl)-N-phenylamino]biphenyl (NPB), 4,4'-bis[N-(3-methylphenyl)-N-phenylamino]biphenyl (TPD), N,N'-di-1-naphtyl-N,N'-diphenyl-1,1'-biphenyl-4,4'-diamine (NPD), N-phenylcarbazole, polyvinylcarbazole, or a combination thereof.

The ETL may include an electron transport material, e.g., tris(8-quinolinolato)aluminum (Alq3), 2-(4-biphenylyl)-5-4-tert-butylphenyl-1,3,4-oxadiazole (PBD), bis(2-methyl-8-quinolinolato)-4-phenylphenolato-aluminum (BAlq), bathocuproine (BCP), triazole (TAZ), phenylquinazoline, or a combination thereof.

In some embodiments, at least one of the organic light emitting layer, the HTL and the ETL need not be individually patterned for each pixel, and may be provided commonly for a plurality of the pixels. In an embodiment, the organic light emitting layer may be provided for the plurality of the pixels, and a color of the each pixel may be achieved by a color filter. In this case, the transparent display device may serve as a white-OLED (W-OLED) device.

In some embodiments, the display layer 200 may include a liquid crystal layer instead of the organic light emitting layer. In this case, the transparent display device may be provided as a liquid crystal display (LCD) device.

A second electrode 210 may be formed on the PDL 180 and the display layer 200. The second electrode 210 may face the first electrode 170 with respect to the display layer 200.

In example embodiments, the second electrode 210 may serve as a common electrode commonly provided for a plurality of the pixels. The second electrode 210 may serve as a cathode of the transparent display device.

In example embodiments, the second electrode 210 may include a metal having a low work function such as Ag, Mg, Al, W, Cu, Ni, Cr, Mo, Ti, Pt, Ta, Nd, Sc, or an alloy thereof. In some example embodiments, the second electrode may include an alloy of Ag and Mg (e.g., AgxMg1-x).

The second electrode 210 may continuously extend on the pixel area PA and the transmission area TA. A thickness of the second electrode 210 may be determined in consideration of a luminescent efficiency in the pixel area PA and a desired transmittance in the transmission area TA.

In some embodiments, the second electrode 210 may be substantially removed from the transmission area TA.

In example embodiments, the thickness of the second electrode 210 may be in a range from about 3 nm (30 Å) to about 12 nm (120 Å). If the thickness of the second electrode 210 exceeds about 12 nm (120) Å, the transmittance in the transmission area TA may be excessively reduced. If the thickness of the second electrode 210 is less than about 3 nm (30 Å), the luminescent efficiency in the pixel area PA may be degraded, and the second electrode 210 need not be formed uniformly. Further, an electrical resistance of the second electrode 210 may be excessively increased.

A capping layer 220 may be formed on the second electrode 210. In example embodiments, the capping layer 220 may cover a substantially entire top surface of the second electrode 210, and may be provided commonly on the pixel area PA and the transmission area TA.

The capping layer 220 may include an organic material having an improved transmissive property. In some embodiments, the capping layer 220 may include a material substantially the same as or similar to the hole transport material. Thus, a light emitting property in the pixel area PA need not be disturbed by the second electrode 210 serving as the cathode.

In example embodiments, a thickness of the capping layer 220 may be determined in consideration of improving or maximizing the transmittance in the transmission area TA, and may be in a range from about 35 nm (350 Å) to about 70 nm (700 Å). The capping layer 220 may have a uniform thickness throughout the pixel area PA and the transmission area TA in some embodiments.

As described above, when the second electrode 210 includes a metal, e.g., Ag and/or Mg and has a predetermined thickness, the thickness of the capping layer 220 may be designed within the above-mentioned range so that the transmittance of the transmission area TA may be maximized.

In some example embodiments, as illustrated in FIG. 3, an encapsulation substrate 250 may be further disposed over the capping layer 220, and a filling layer 240 may be further included between the capping layer 220 and the encapsulation substrate 250.

The encapsulation substrate 250 may include a glass substrate or a polymer substrate. The filling layer 240 may include, e.g., a substantially transparent or transmissive organic material.

In some embodiments, an organic/inorganic stacked layers may be utilized as a sealing film instead of the encapsulation substrate 250 and the filling layer 240. In some embodiments, a thin film encapsulation (TFE) may be utilized as the sealing film.

In some embodiments, the filling layer 240 may include an organic material having a refractive index in a range from about 1.4 to about 1.6. In some embodiments, the capping layer 220 may include an organic material having a refractive index of at least about 1.85. In some embodiments, the capping layer 220 may include an organic material having a refractive index in a range from about 1.85 to about 2.

Referring to FIG. 4, a thickness of a capping layer 225 at the pixel area PA is different from that at the transmission area TA in this embodiment. In this case, the capping layer 225 may include a first portion 225a and a second portion 225b. The first portion 225a may substantially cover the pixel area PA, and may be relatively thick. The second portion 225b may substantially cover the transmission area TA, and may be relatively thin.

A thickness of the first portion 225a may be determined in consideration of improving (e.g., maximizing) the luminescent efficiency in the pixel area PA. In some embodiments, the thickness of the first portion 225a may be determined as a thickness for minimizing transmittance. For example, the thickness of the first portion 225a may be in a range from about 70 nm (700 Å) to about 90 nm (900 Å) in consideration of the material and/or the thickness of the second electrode 210 as described above.

A thickness of the second portion 225b may be determined in consideration of improving (e.g., maximizing) the transmittance in the transmission area TA. In example embodiments, the thickness of the second portion 225b may be in a range from about 35 nm (350 Å) to about 70 nm (700 Å).

As described above, the thickness of the capping layer 225 may be differentiated so that the luminescent efficiency and transmittance may be improved or optimized according to the parts of the transparent display device. Therefore, the transparent display device having an improved display quality may be achieved.

In a comparative example, the second electrode 210 formed on the transmission area TA may be removed by an additional etching or patterning process for improving the transmittance thereon. However, a process complexity may be increased due to an addition of an etching mask, a mechanical strength of the display device may be reduced, and an electrical resistance of the second electrode 210 may be increased.

However, according to example embodiments, the second electrode 210 may continuously extend into the pixel area PA and the transmission area TA, and the thickness of the capping layer 225 may be controlled in consideration of an impedance matching with the second electrode 210 so that the transmittance of the transparent display device may be improved.

Further, in some example embodiments, even though the second electrode 210 is substantially removed from the transmission area TA, the thickness of the capping layer 225 may be designed to improve the luminescent efficiency and the transmittance according to the areas of the transparent display device.

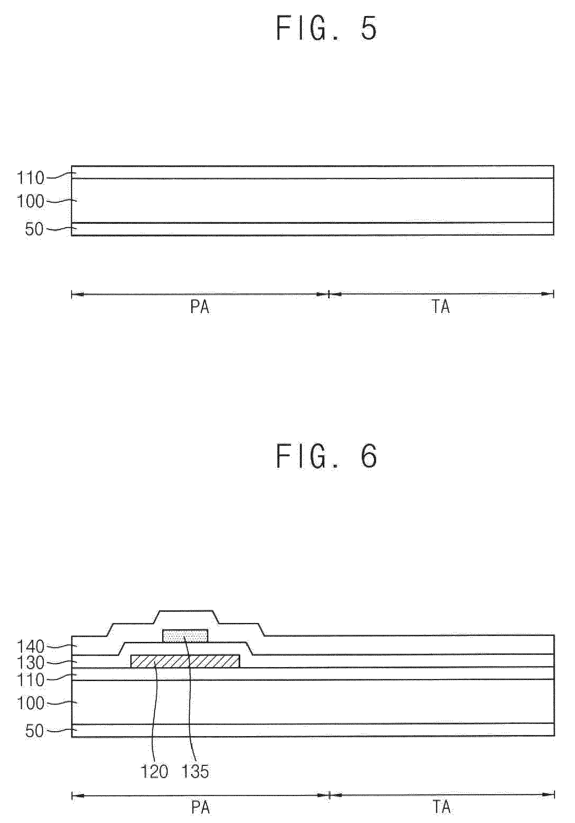

FIGS. 5 to 11 are cross-sectional views illustrating a method of manufacturing a transparent display device in accordance with example embodiments. For example, FIGS. 5 to 11 illustrate a method of manufacturing the transparent display device illustrated in FIG. 3.

Referring to FIG. 5, a substrate 100 may be formed on a carrier substrate 50, and a barrier layer 110 may be formed on the substrate 100.

The carrier substrate 50 may serve as a supporter of the substrate 100 during a manufacturing process of the transparent display device. For example, a glass substrate or a metal substrate may be utilized as the carrier substrate 50.

The substrate 100 may be formed using a transparent polymer resin such as a polyimide-based resin. For example, a precursor composition containing a polyimide precursor may be coated on the carrier substrate 50 by, e.g., a spin coating process to form a coating layer. The coating layer may be thermally cured to form the substrate 100.

The polyimide precursor may include a diamine and a dianhydride. The precursor composition may be prepared by dissolving the polyimide precursor in an organic solvent. The organic solvent may include, e.g., N-methyl-2-pyrrolidone (NMP), dimethylformamide (DMF), tetrahydrofuran (THF), triethylamine (TEA), ethylacetate, dimethylsulfoxide (DMSO) or an ethylene glycol-based ether solvent. These may be used alone or in a combination thereof.

The diamine and the dianhydride may be polymerized by the thermal curing process so that a polyamic acid may be created, and the polyamic acid may be additionally cured and condensed to form the polyimide-based resin.

A predetermined area of the substrate 100 may be allotted as a pixel area PA, and a remaining area except for the pixel area PA may be allotted as a transmission area TA.

The barrier layer 110 may substantially cover an entire top surface of the substrate 100, and may be formed of silicon oxide, silicon nitride and/or silicon oxynitride.

Referring to FIG. 6, an active pattern 120, a gate electrode 135 and additional insulation layers may be formed on the barrier layer 110.

The active pattern 120 may be formed on a portion of the barrier layer 110 on the pixel area PA. For example, a semiconductor layer including amorphous silicon or polysilicon may be formed on the barrier layer 110, and then may be patterned to form the active pattern 120.

In some embodiments, a crystallization process, e.g., a low temperature polycrystalline silicon (LTPS) process or a laser crystallization process may be further performed after the formation of the semiconductor layer.

In some embodiments, the semiconductor layer may be formed of an oxide semiconductor such as IGZO, ZTO or ITZO.

A gate insulation layer 130 covering the active pattern 120 may be formed on the barrier layer 110. The gate insulation layer 130 may be formed of silicon oxide, silicon nitride and/or silicon oxynitride.

As illustrated in FIG. 6, the gate insulation layer 130 may extend continuously on the pixel area PA and the transmission area TA. In some embodiments, the gate insulation layer 130 may be patterned to be present selectively on the pixel area PA.

The gate electrode 135 may be formed on the gate insulation layer 130, and may be substantially superimposed over the active pattern 120.

For example, a first conductive layer may be formed on the gate insulation layer 130. The first conductive layer may be patterned by, e.g., a photo-lithography process to form the gate electrode 135. The first conductive layer may be formed using a metal, an alloy or a metal nitride. The first conductive layer may be formed by depositing a plurality of metal layers.

The gate electrode 135 may be formed together with a scan line S illustrated in FIG. 2. For example, the gate electrode 135 and the scan line S may be formed from the first conductive layer by substantially the same etching process, and the scan line S may be integral with the gate electrode 135.

In some embodiments, impurities may be implanted into the active pattern 120 using the gate electrode 135 as an ion-implantation mask such that a source region and a drain region may be formed at both ends of the active pattern 120.

An insulating interlayer 140 covering the gate electrode 135 may be formed on the gate insulation layer 130. The insulating interlayer 140 may include stepped portions according to profiles of the active pattern 120 and the gate electrode 135. The insulating interlayer 140 may be formed of silicon oxide, silicon nitride and/or silicon oxynitride.

As illustrated in FIG. 6, the insulating interlayer 140 may extend in both the pixel area PA and the transmission area TA. In some embodiments, at least a portion of the insulating interlayer 140 formed on the transmission area TA may be removed.

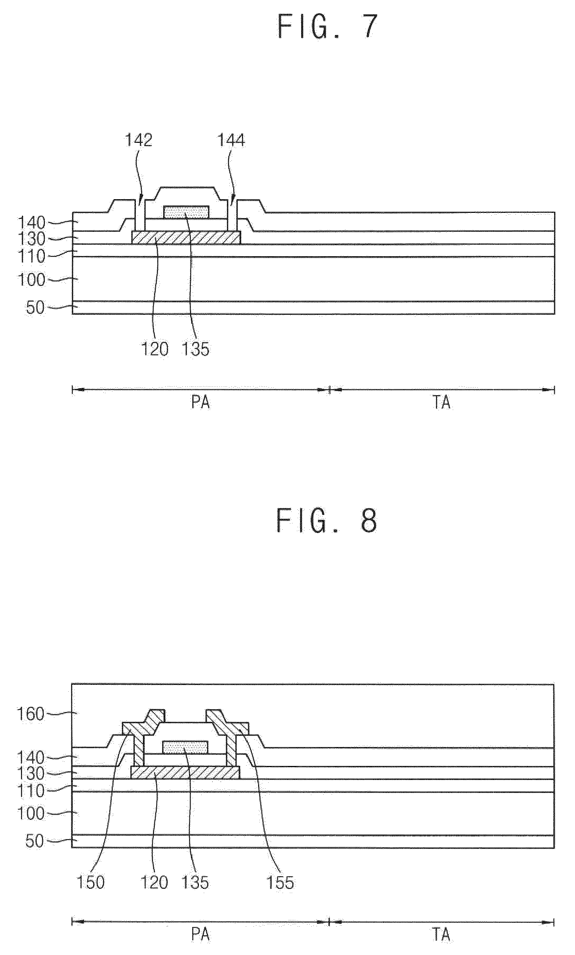

Referring to FIG. 7, the insulating interlayer 140 and the gate insulation layer 130 may be partially removed by, e.g., a first photolithography process to form a first contact hole 142 and a second contact hole 144.

The first contact hole 142 and the second contact hole 144 may be formed through the insulating interlayer 140 and the gate insulation layer 130 such that a top surface of the active pattern 120 may be partially exposed. For example, the source region and the drain region of the active pattern 120 may be exposed through the first contact hole 142 and the second contact hole 144, respectively.

Referring to FIG. 8, a source electrode 150 and a drain electrode 155 may be formed in the first contact hole 142 and the second contact hole 144, respectively. The source electrode 150 and the drain electrode 155 may be in contact with the source region and the drain region, respectively.

For example, a second conductive layer sufficiently filling the first contact hole 142 and the second contact hole 144 may be formed on the insulating interlayer 140. The second conductive layer may be patterned by a photo-lithography process to form the source electrode 150 and the drain electrode 155. The second conductive layer may be formed using a metal, a metal nitride or an alloy.

Accordingly, a TFT including the active pattern 120, the gate insulation layer 130, the gate electrode 135, the source electrode 150 and the drain electrode 155 may be formed on the pixel area PA of the substrate 100. For example, a plurality of pixels may be included in the pixel area PA as illustrated in FIGS. 1 and 2, and at least one TFT may be formed for each pixel.

Additionally, a pixel circuit including the TFT, a data line D and the scan line S may be formed on the substrate 100. The source electrode 150 may be electrically connected to the data line D as illustrated in FIG. 2. For example, the source electrode 150, the drain electrode 155 and the data line D may be formed from the second conductive layer by substantially the same etching process.

A via insulation layer 160 may be formed to cover the insulating interlayer 140, the source electrode 150 and the drain electrode 155. The via insulation layer 160 may extend commonly on the pixel area PA and the transmission area TA, and may have a substantially planar or leveled upper surface. The via insulation layer 160 may serve as a planarization layer for the transparent display device or a BP structure.

The via insulation layer 160 may be formed using an organic material such as polyimide, an epoxy-based resin, an acryl-based resin or polyester by a spin coating process or a slit coating process.

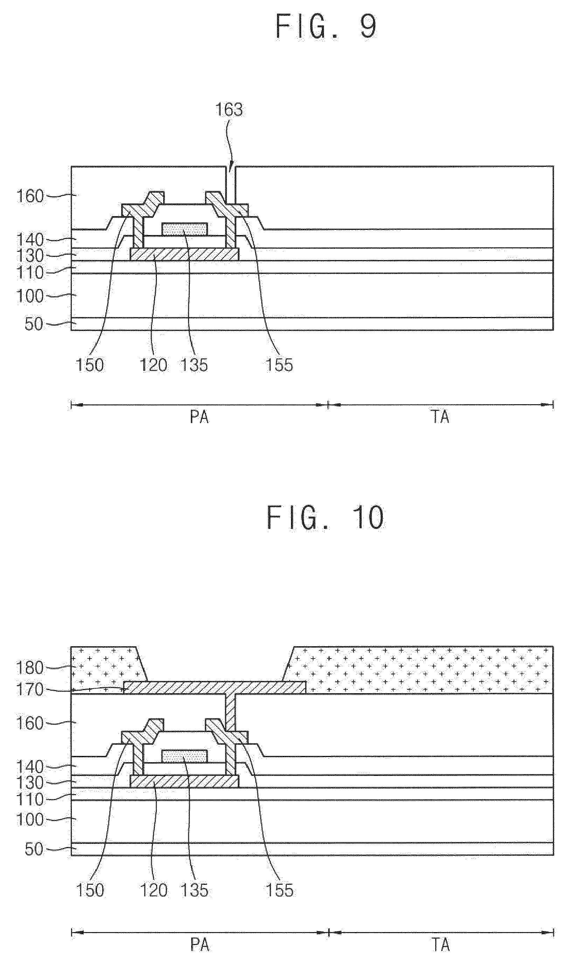

Referring to FIG. 9, the via insulation layer 160 may be partially removed by, e.g., a second photolithography process to form a via hole 163.

In example embodiments, a top surface of the drain electrode 155 may be at least partially exposed through the via hole 163.

Referring to FIG. 10, a first electrode 170 may be formed on the via insulation layer 160 so that the BP structure may be obtained.

For example, a third conductive layer filling the via hole 163 may be formed on the via insulation layer 160 and the exposed drain electrode 155, and may be patterned to form the first electrode 170. The first electrode 170 may serve as a pixel electrode and/or an anode of the transparent display device. A portion of the first electrode 170 formed in the via hole 163 may be defined as a via structure for an interconnection with the drain electrode 155.

The third conductive layer may be formed of a metal such as Ag, Mg, Al, W, Cu, Ni, Cr, Mo, Ti, Pt, Ta, Nd, Sc, etc., or an alloy thereof.

The barrier layer 110, the semiconductor layer, the gate insulation layer 130, the insulating interlayer 140, and the first to third conductive layers may be formed by at least one of a chemical vapor deposition (CVD) process, a plasma enhanced chemical vapor deposition (PECVD) process, a high density plasma-chemical vapor deposition (HDP-CVD) process, a thermal evaporation process, a vacuum deposition process, a spin coating process, a sputtering process, an atomic layer deposition (ALD) process and a printing process.

A PDL 180 may be formed on the via insulation layer 160 to cover a peripheral portion of the first electrode 170. For example, a photosensitive organic material such as a polyimide resin or an acryl resin may be coated, and then exposure and developing processes may be performed to form the PDL 180. In some embodiments, the PDL 180 may be formed of a polymeric material or an inorganic material by a printing process, e.g., an inkjet printing process.

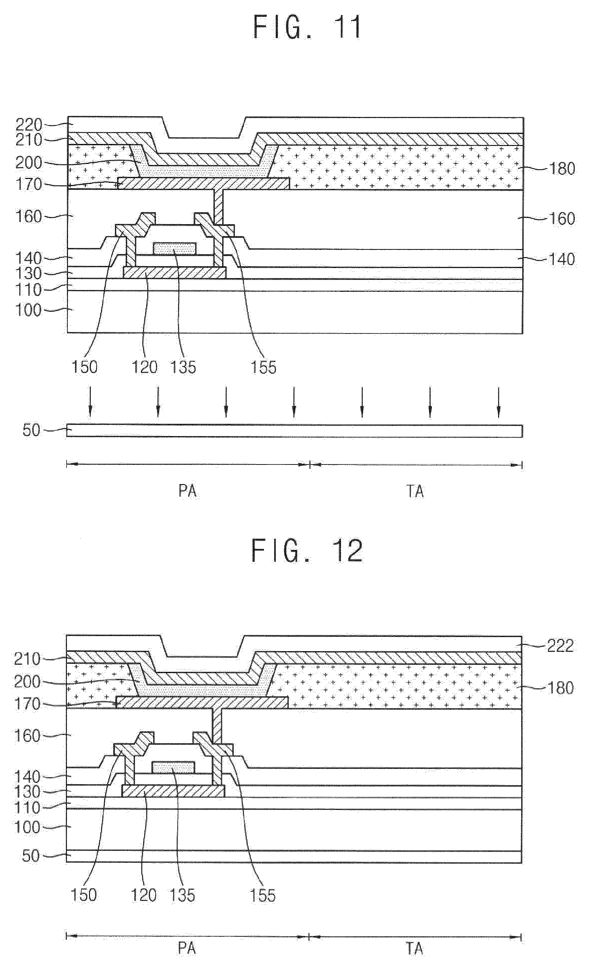

Referring to FIG. 11, a display layer 200, a second electrode 210 and a capping layer 220 may be sequentially formed on the PDL 180 and the first electrode 170.

The display layer 200 may be formed using an organic light emitting material for generating a red color of light, a blue color of light or a green color of light on each first electrode 170 exposed by the PDL 180. For example, the display layer 200 may be formed by a spin coating process, a roll printing process, a nozzle printing process, an inkjet process, etc., using a fine metal mask (FMM) that may include an opening through which a region corresponding to a red pixel Pr, a green pixel Pg, or a blue pixel Pb is exposed. Accordingly, an organic light emitting layer including the organic light emitting material may be individually formed in each pixel.

In some embodiments, an HTL may be formed before the formation of the organic light emitting layer using the above-mentioned hole transport material. An ETL may be also formed on the organic light emitting layer using the above-mentioned electron transport material. The HTL and the ETL may be included in the display layer 200, and may be patterned for each pixel by processes substantially the same as or similar to those for the organic light emitting layer.

For example, as illustrated in FIG. 11, the display layer 200 of each pixel may be confined by a sidewall of the PDL 180.

In some embodiments, at least one of the organic light emitting layer, the HTL and the ETL need not be individually patterned for each pixel, and may be formed continuously in a plurality of the pixels. In an embodiment, the organic light emitting layer may be formed for the plurality of the pixels, and the color of an individual pixel may be achieved by a color filter. In this case, the transparent display device may serve as a white-OLED (W-OLED) device.

A metal having a low work function such as Al, Mg, Ag, W, Cu, Ni, Cr, Mo, Ti, Pt, Ta, Nd or Sc, or an alloy of the metals may be deposited on the display layer 200 to form a second electrode 210. The second electrode 210 may serve as a common electrode and/or a cathode of the transparent display device.

For example, an open mask including an opening through which the pixel area PA and the transmission area TA are commonly exposed may be used to deposit the metal by, e.g., a sputtering process for the formation of the second electrode 210. The second electrode 210 may be formed commonly for the pixel area PA and the transmission area TA without an additional patterning process, so that a process may be simplified, and an electrical resistance of the second electrode 210 may be reduced.

In some embodiments, the second electrode 210 may be patterned to be removed substantially from the transmission area TA.

In some example embodiments, the second electrode 210 may be formed of Ag, Mg or an alloy thereof. Further, a thickness of the second electrode 210 may be determined for improving a luminescent efficiency in the pixel area PA and obtaining a desired transmittance in the transmission area TA.

In some embodiments, the second electrode 210 may have the thickness in a range from about 3 nm (30 Å) to about 12 nm (120 Å).

Subsequently, a capping layer 220 may be formed on the second electrode 210. In example embodiments, the capping layer 220 may extend continuously on the pixel area PA and the transmission area TA, and may have a substantially uniform thickness throughout the pixel area PA and the transmission area TA.

The capping layer 220 may be formed of a hole transport-type organic material by a coating process, e.g., a spin coating process. For example, the capping layer 220 may be formed of an organic material having a refractive index of at least about 1.85, e.g., in a range from about 1.85 to about 2, so that an optical consistency with the PDL 180 and/or the via insulation layer 160 including an organic material may be enhanced.

In example embodiments, a thickness of the capping layer 220 may be determined for maximizing the transmittance in the transmission area TA in consideration of the thickness of the second electrode 210 including Ag and/or Mg. The capping layer 220 may have a thickness in a range from about 35 nm (350 Å) to about 70 nm (700 Å).

Subsequently, as illustrated in FIG. 11, the carrier substrate 50 may be detached from the substrate 100. For example, when the substrate 100 may be a plastic substrate, the carrier substrate 50 may be detached by a laser-lift process or by applying a mechanical tension.

In some example embodiments, as illustrated in FIG. 3, a filling layer 240 and an encapsulation substrate 250 may be stacked on the capping layer 220. The filling layer 240 may be formed of an organic material having a refractive index in a range from about 1.4 to about 1.6 in consideration of an optical consistency with the capping layer 220.

According to example embodiments as described above, the second electrode 210 may be formed commonly on the pixel area PA and the transmission area TA, and an optical impedance due to a metallic material in the transmission area TA may be adjusted by the capping layer 220 to improve a transmittance of the transparent display device.

Therefore, a process failure and a degradation of display quality caused by a selective patterning of the second electrode 210 may be avoided while obtaining an enhanced transmittance.

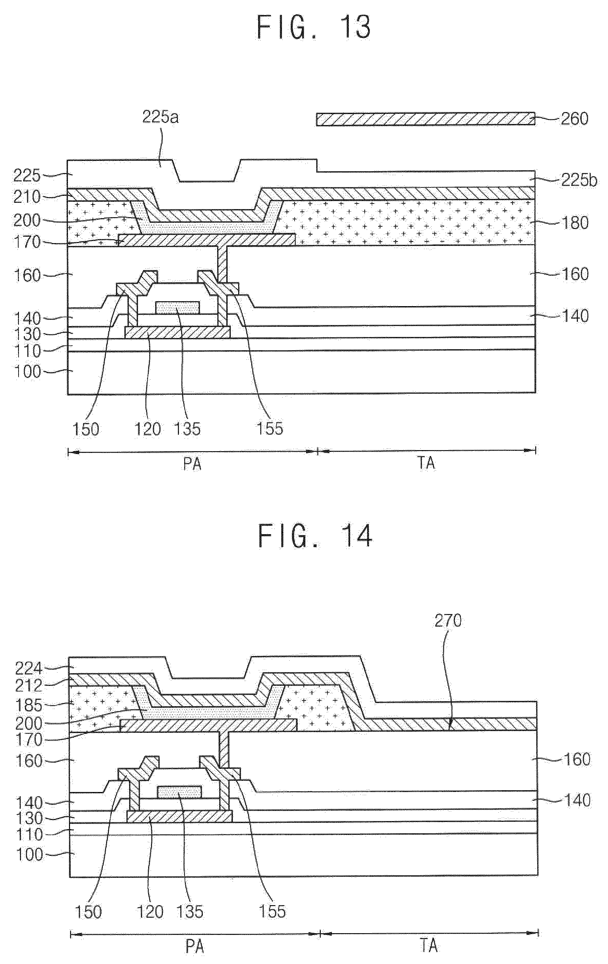

FIGS. 12 and 13 are cross-sectional views illustrating a method of manufacturing a transparent display device in accordance with example embodiments.

For example, FIGS. 12 and 13 illustrate a method of manufacturing a transparent display device of FIG. 4. Detailed descriptions on processes and/or materials substantially the same as or similar to those illustrated with reference to FIGS. 5 to 11 are omitted herein.

Referring to FIG. 12, the BP structure may be formed by processes substantially the same as or similar to those illustrated with reference to FIGS. 5 to 11, and the display layer 200 and the second electrode 210 may be formed on the BP structure.

In example embodiments, a preliminary capping layer 222 may be formed on the second electrode 210. The preliminary capping layer 222 may be formed to have a material and a thickness substantially the same as or similar to those of the capping layer 220 illustrated in FIG. 11. The preliminary capping layer 222 may have a thickness in a range from about 35 nm (350 Å) to about 70 nm (700 Å).

For example, the preliminary capping layer 222 may be formed by a coating process or a printing process using an open mask through which the pixel area PA and the transmission area TA may be exposed.

Referring to FIG. 13, an additional capping layer may be formed selectively on the pixel area PA. Accordingly, a capping layer 225 including a first portion 225a and a second portion 225b that may have different thicknesses may be formed on the pixel area PA and the transmission area TA.

In example embodiments, a mask 260 selectively covering the transmission area TA may be placed on the preliminary capping layer 222. A coating process using the mask 260 may be performed such that the additional capping layer may be formed on a portion of the preliminary capping layer 222 of the pixel area PA. Thus, a thickness of the capping layer 225 may be increased on the pixel area PA to form the first portion 225a.

In example embodiments, the preliminary capping layer 222 illustrated in FIG. 12 may be formed to have a thickness for improving a transmittance (e.g., maximizing the transmittance) in the transmission area TA. Subsequently, as illustrated in FIG. 13, a thickness of the additional capping layer selectively formed on the pixel area PA may be determined as a thickness for maximizing a luminescent efficiency or minimizing a transmittance in the pixel area PA.

Accordingly, the first portion 225a of the capping layer 225 may have a thickness in a range from about 70 nm (700 Å) to about 90 nm (900 Å). The second portion 225b of the capping layer 225 may have a thickness in a range from about 35 nm (350 Å) to about 70 nm (700 Å).

Subsequently, as illustrated with reference to FIG. 11, the carrier substrate 50 may be detached from the substrate 100.

As described above, the thickness of the capping layer 225 may be differentiated under a material and a thickness of the second electrode 210 previously formed, so that the luminescent efficiency and the transmittance may be optimized individually on the pixel area PA and the transmission area TA. Therefore, the transparent display device having an enhanced display quality may be achieved.

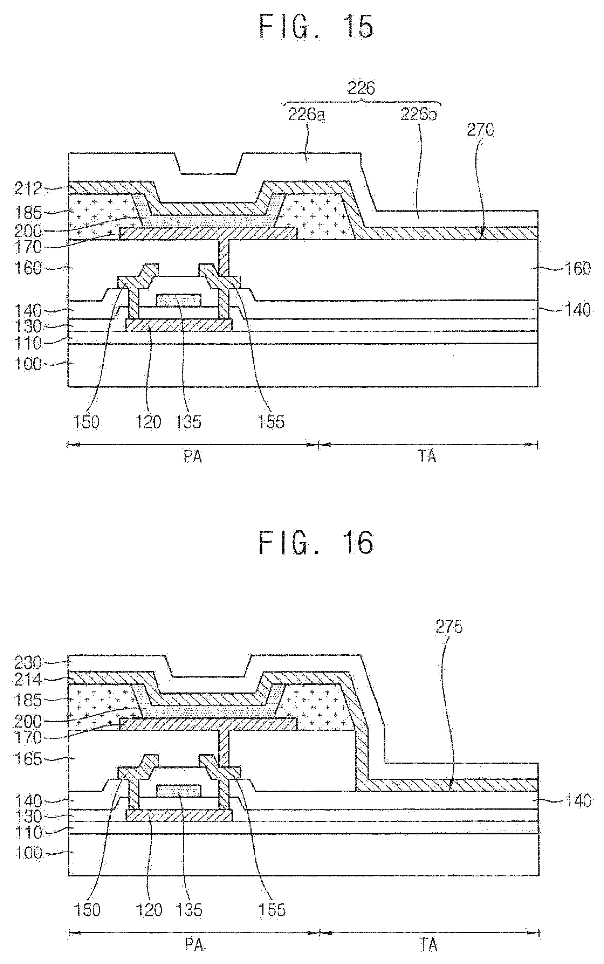

FIGS. 14 and 15 are cross-sectional views illustrating transparent display devices in accordance with some example embodiments.

The transparent display device of FIGS. 14 and 15 may have elements and/or constructions substantially the same as or similar to those illustrated in FIGS. 3 and 4 except for a stacked structure on the transmission area TA. Thus, detailed descriptions on repeated elements and/or structures are omitted herein, and like reference numerals are used to designate like elements.

Referring to FIG. 14, a PDL 185 may be substantially removed from the transmission area TA. For example, the PDL 185 may be selectively printed on a boundary between the pixel area PA and the transmission area TA, and a boundary between the display areas DA illustrated in FIG. 1

In example embodiments, a transmitting window 270 may be defined by a top surface of the via insulation layer 160 and a sidewall of the PDL 185. The transmitting window 270 may be formed by the PDL 185, so that a transmittance in the transmission area TA may be further improved.

A second electrode 212 may be formed conformally along a surface of the PDL 185, an upper surface of the display layer 200 and the top surface of the via insulation layer 160. As described above, the second electrode 212 may have a thickness in a range from about 3 nm (30 Å) to about 12 nm (120 Å).

A capping layer 224 may be formed on the second electrode 212 to have a thickness for improving the transmittance in the transmission area TA. As described above, the capping layer 224 may be formed throughout the pixel area PA and the transmission area TA, and may have a thickness in a range from about 35 nm (350 Å) to about 70 nm (700 Å).

Referring to FIG. 15, a capping layer 226 may have different thicknesses at the pixel area PA and the transmission area TA. In this case, the capping layer 226 may be formed by processes substantially the same as or similar to those illustrated with reference to FIGS. 12 and 13.

The capping layer 226 may include a first portion 226a and a second portion 226b. The first portion 226a may be formed on the pixel area PA, and may have a thickness in a range from about 70 nm (700 Å) to about 90 nm (900 Å). The second portion 226b may cover the transmission area TA or the transmitting window 270, and may have a thickness in a range from about 35 nm (350 Å) to about 70 nm (700 Å).

As illustrated in FIGS. 3 and 4, a filling layer may be formed on the capping layer 224 and 226 so that an upper portion of the transparent display device may be planarized. An encapsulation substrate may be further disposed on the filling layer.

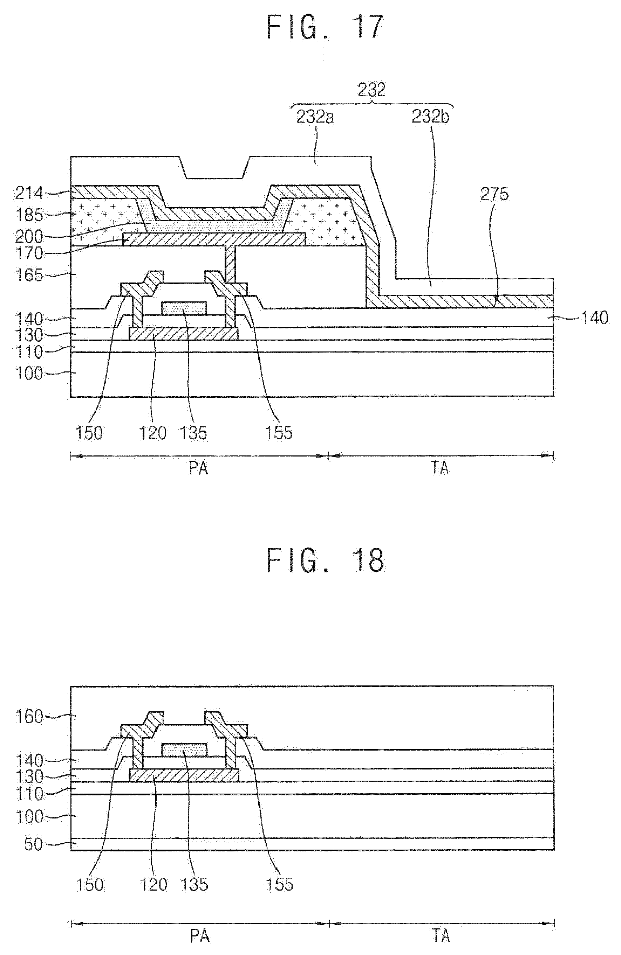

FIGS. 16 and 17 are cross-sectional views illustrating transparent display devices in accordance with some example embodiments.

The transparent display device of FIGS. 16 and 17 may have elements and/or constructions substantially the same as or similar to those illustrated in FIGS. 14 and 15 except for a stacked structure on the transmission area TA. Thus, detailed descriptions on repeated elements and/or structures are omitted herein, and like reference numerals are used to designate like elements.

Referring to FIG. 16, the via insulation layer 160 illustrated in FIG. 14 may be substantially removed from the transmission area TA. Accordingly, a via insulation pattern 165 covering the pixel circuit or the TFT may be formed selectively on the pixel area PA. For example, a transmitting window 275 may be defined by a top surface of the insulating interlayer 140, and sidewalls of the PDL 185 and the via insulation pattern 165.

A second electrode 214 may be formed conformally along the surface of the PDL 185, the upper surface of the display layer 200 and a surface of the transmitting window 275. As described above, the second electrode 214 may have a thickness in a range from about 3 nm (30 Å) to about 12 nm (120 Å).

A capping layer 230 may be formed on the second electrode 214 to have a thickness for improving the transmittance in a transmission area TA. As described above, the capping layer 230 may be formed throughout the pixel area PA and the transmission area TA, and may have a thickness in a range from about 35 nm (350 Å) to about 70 nm (700 Å).

Referring to FIG. 17, as also illustrated with reference to FIG. 15, a capping layer 232 may have different thicknesses on the pixel area PA and the transmission area TA.

The capping layer 232 may include a first portion 232a and a second portion 232b. The first portion 232a may be formed on the pixel area PA, and may have a thickness in a range from about 70 nm (700 Å) to about 90 nm (900 Å). The second portion 232b may cover the transmission area TA or the transmitting window 275, and may have a thickness in a range from about 35 nm (350 Å) to about 70 nm (700 Å).

As illustrated in FIGS. 3 and 4, a filling layer may be formed on the capping layer 230 and 232 so that an upper portion of the transparent display device may be planarized. An encapsulation substrate may be further disposed on the filling layer.

FIGS. 18 to 20 are cross-sectional views illustrating a method of manufacturing a transparent display device in accordance with some example embodiments. For example, FIGS. 18 to 20 illustrate a method of manufacturing the transparent display devices of FIGS. 16 and 17.

Detailed descriptions on processes and/or materials substantially the same as or similar to those illustrated with reference to FIGS. 5 to 11, and FIGS. 12 and 13 are omitted herein.

Referring to FIG. 18, processes substantially the same as or similar to those illustrated with reference to FIGS. 5 to 8 may be performed. Accordingly, the substrate 100 and the barrier layer 110 may be formed on the carrier substrate 50, and the transistor including the active pattern 120, the gate insulation layer 130, the gate electrode 135, the source electrode 150 and the drain electrode 155 may be formed. The insulating interlayer 140 and the via insulation layer 160 covering the transistor may be further formed.

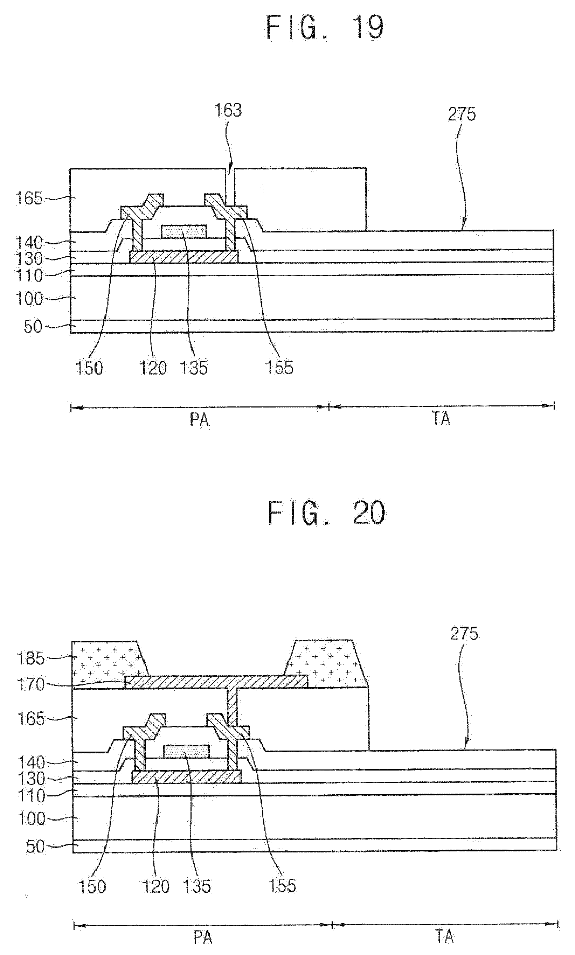

Referring to FIG. 19, the via insulation layer 160 may be partially removed to form a via hole 163 and transmitting window 275.

In example embodiments, the transmitting window 275 may be formed concurrently by a second photolithography process (see FIG. 9) for the formation of the via hole 163. For example, a portion of the via insulation layer 160 formed on the transmission area TA may be also removed while forming the via hole 163, such that a via insulation pattern 165 may be formed selectively on the pixel area PA.

In some embodiments, a top surface of the insulating interlayer 140 may be exposed by the transmitting window 275. Accordingly, the transmitting window 275 may be defined by the top surface of the insulating interlayer 140, and a sidewall of the via insulation pattern 165.

Referring to FIG. 20, as also illustrated in FIG. 10, the first electrode 170 filling the via hole 163 may be formed on the via insulation pattern 165. A PDL 185 partially covering the first electrode 170 may be formed on a top surface of the via insulation pattern 165.

For example, the PDL 185 may be printed on the top surface of the via insulation pattern 165 such that the first electrode 170 of each pixel may be exposed.

FIGS. 18 and 20 illustrate that the via insulation layer 160 may be etched concurrently by a photo-lithography process for the formation of the via hole 163. However, the via insulation layer 160 may be patterned concurrently by a patterning process for removing a portion of the PDL 185 formed on the transmission area TA to form the via insulation pattern 165.

In some example embodiments, a process substantially the same as or similar to that illustrated with reference to FIG. 11 may be performed to form the display layer 200, the second electrode 214 and the capping layer 230 illustrated in FIG. 16.

In some example embodiments, processes substantially the same as or similar to those illustrated with reference to FIGS. 12 and 13 may be performed to form the capping layer 232 having different thicknesses at the pixel area PA and the transmission area TA as illustrated in FIG. 17.

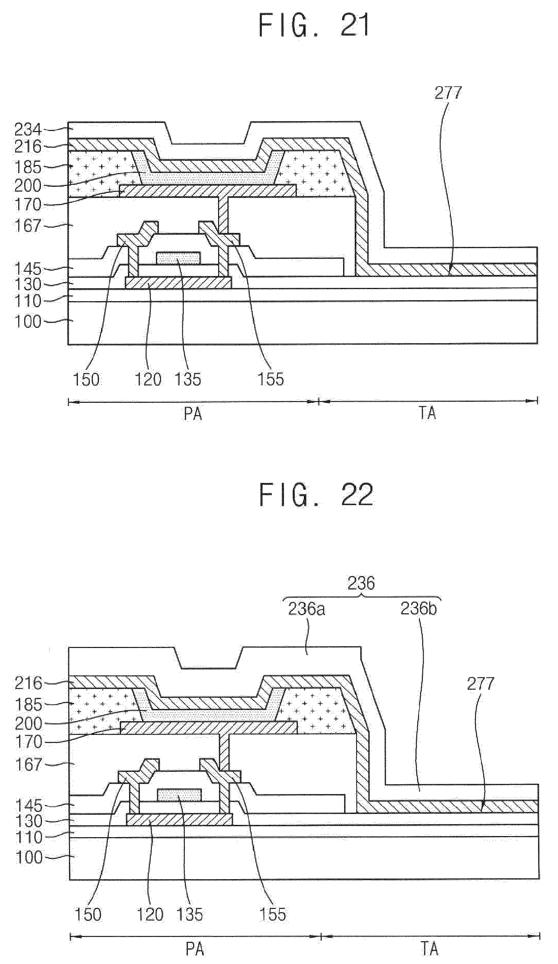

FIGS. 21 and 22 are cross-sectional views illustrating transparent display devices in accordance with some example embodiments.

The transparent display device of FIGS. 21 and 22 may have elements and/or constructions substantially the same as or similar to those illustrated in FIGS. 16 and 17 except for a stacked structure on the transmission area TA. Thus, detailed descriptions on repeated elements and/or structures are omitted herein, and like reference numerals are used to designate like elements.

Referring to FIG. 21, the insulating interlayer 140 illustrated in FIG. 16 may be substantially removed from the transmission area TA. Accordingly, an insulating interlayer pattern 145 covering the pixel circuit or the TFT may be formed selectively on the pixel area PA.

In some embodiments, the insulating interlayer pattern 145 may be included in a via insulation pattern 167. In this case, a transmitting window 277 may be defined by a top surface of the gate insulation layer 130, and sidewalls of the PDL 185 and the via insulation pattern 167.

A second electrode 216 may be formed conformally along a surface of the PDL 185, an upper surface of the display layer 200 and a surface of the transmitting window 277. As described above, the second electrode 216 may have a thickness in a range from about 3 nm (30 Å) to about 12 nm (120 Å).

A capping layer 234 may be formed on the second electrode 216 to have a thickness for improving a transmittance in the transmission area TA. As described above, the capping layer 234 may be formed throughout the pixel area PA and the transmission area TA, and may have a thickness in a range from about 35 nm (350 Å) to about 70 nm (700 Å).

Referring to FIG. 22, a capping layer 236 may have different thicknesses at the pixel area PA and the transmission area TA.

The capping layer 236 may include a first portion 236a and a second portion 236b. The first portion 236a may be formed on the pixel area PA, and may have a thickness in a range from about 70 nm (700 Å) to about 90 nm (900 Å). The second portion 236b may cover the transmission area TA or the transmitting window 277, and may have a thickness in a range from about 35 nm (350 Å) to about 70 nm (700 Å).

As illustrated in FIGS. 3 and 4, a filling layer may be formed on the capping layer 234 and 236 so that an upper portion of the transparent display device may be planarized. An encapsulation substrate may be further disposed on the filling layer.

As described above, portions of the via insulation layer 160 and the insulating interlayer 140 may be substantially removed from the transmission area TA to form the transmitting window 275 and 277. Thus, a light transmitting distance in the transmission area TA may be reduced so that the transmittance in the transmission area TA may be further improved.

In some embodiments, the gate insulation layer 130 may be removed from the transmission area TA such that the transmitting window is expanded.

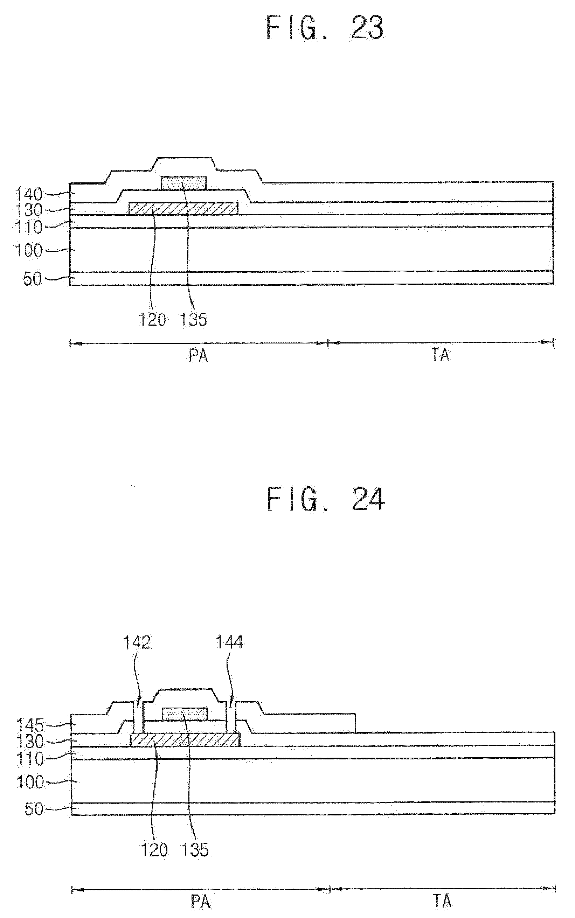

FIGS. 23 to 27 are cross-sectional views illustrating a method of manufacturing a transparent display device in accordance with some example embodiments. For example, FIGS. 23 to 27 illustrate a method of manufacturing the transparent display devices of FIGS. 21 and 22.

Detailed descriptions on processes and/or materials substantially the same as or similar to those illustrated with reference to FIGS. 5 to 11, and FIGS. 12 and 13 are omitted herein.

Referring to FIG. 23, processes substantially the same as or similar to those illustrated with reference to FIGS. 5 and 6 may be performed.

In example embodiments, the substrate 100 may be formed on the carrier substrate 50, and the barrier layer 110, the active pattern 120, the gate insulation layer 130, the gate electrode 135 and the insulating interlayer 140 may be sequentially formed on the substrate 100.

Referring to FIG. 24, as also illustrated with reference to FIG. 7, a first photolithography process may be performed such that portions of the insulating interlayer 140 and the gate insulation layer 130 formed on the pixel area PA may be partially etched to form the first and second contact holes 142 and 144.

In example embodiments, a portion of the insulating interlayer 140 formed on the transmission area TA may be also removed by the first photolithography process. Accordingly, an insulating interlayer pattern 145 may be formed selectively on the pixel area PA.

In some embodiments, a portion of the gate insulation layer 130 formed on the transmission area TA may be also removed by the first photolithography process.

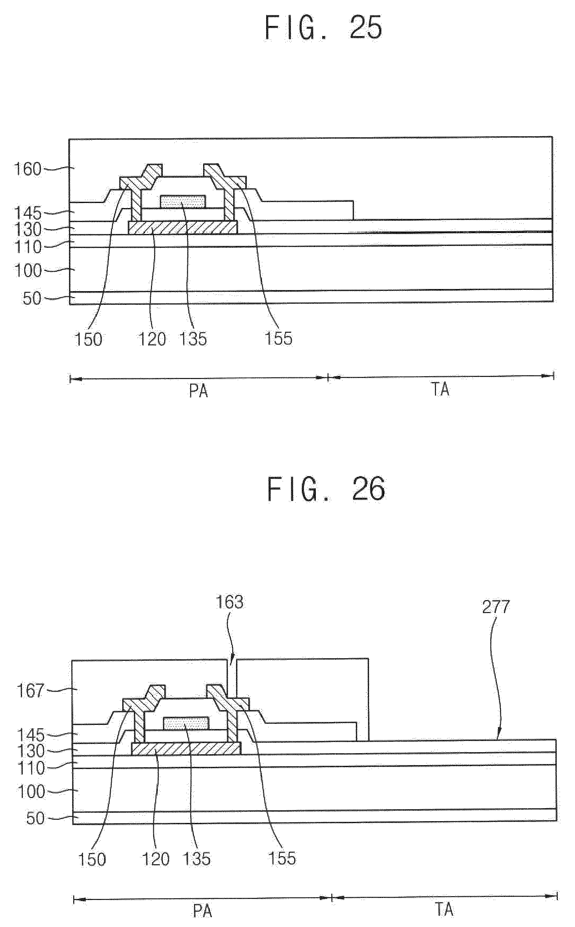

Referring to FIG. 25, a process substantially the same as or similar to that illustrated with reference to FIG. 8 may be performed.

Accordingly, the source electrode 150 and the drain electrode 155 may be formed in the first contact hole 142 and the second contact hole 144, respectively. The via insulation layer 160 covering the source electrode 150 and the drain electrode 155 may be formed on the insulating interlayer pattern 145 and the gate insulation layer 130.

Referring to FIG. 26, a process substantially the same as or similar to that illustrated with reference to FIG. 19 may be performed.

For example, a second photolithography process may be performed so that the via hole 163 exposing the drain electrode 155 may be formed on the pixel area PA, and a portion of the via insulation layer 160 formed on the transmission area TA may be at least partially removed. Accordingly, a via insulation pattern 167 may be formed selectively on the pixel area PA.

In some embodiments, the insulating interlayer pattern 145 may be included in the via insulation pattern 167 on the pixel area PA. Additionally, a transmitting window 277 through which, e.g., a top surface of the gate insulation layer 130 is exposed may be defined.

In some embodiments, as described above, if the gate insulation layer 130 is also removed from the transmission area TA, the barrier layer 110 may be exposed by the transmitting window 277.

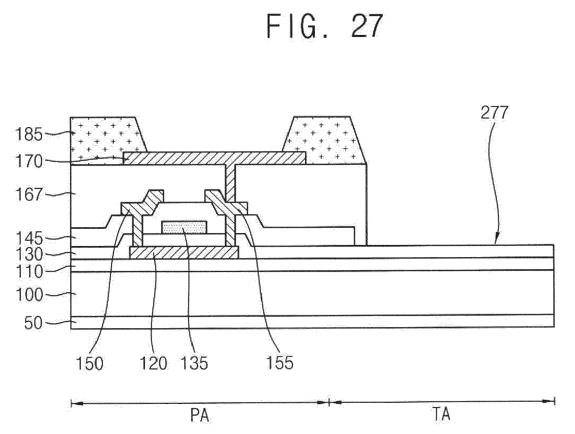

Referring to FIG. 27, as also illustrated with reference to FIG. 20, the first electrode 170 filling the via hole 163 may be formed on the via insulation pattern 167, and the PDL 185 partially covering the first electrode 170 may be formed on the via insulation pattern 167.

In some example embodiments, a process substantially the same as or similar to that illustrated with reference to FIG. 11 may be performed to form the display layer 200, the second electrode 216 and the capping layer 234 illustrated in FIG. 21.

In some example embodiments, the capping layer 236 may be formed to have different thicknesses at the pixel area PA and the transmission area TA through processes substantially the same as or similar to those illustrated with reference to FIGS. 12 and 13. Accordingly, the transparent display device of FIG. 22 may be achieved.

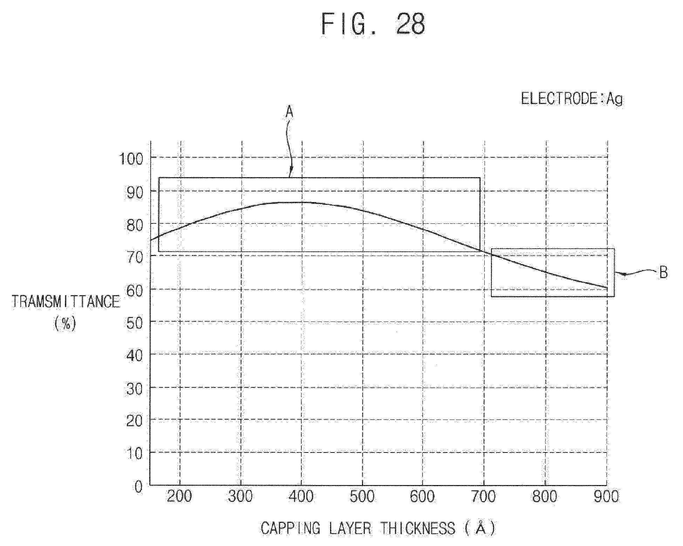

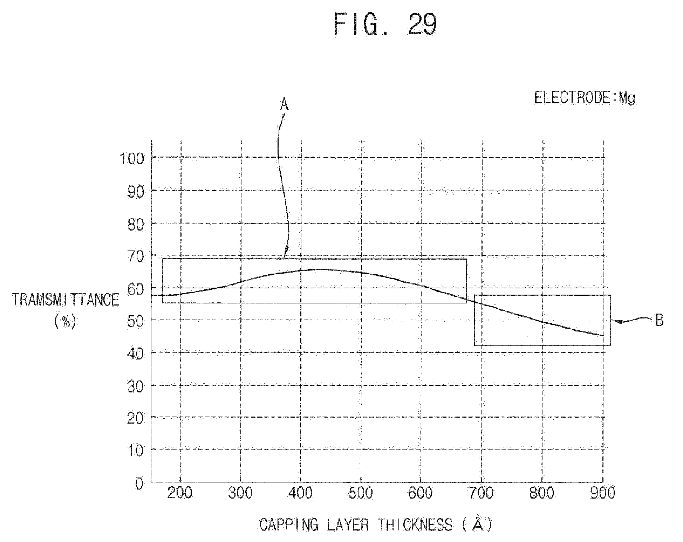

FIGS. 28 and 29 are graphs showing a transmittance change in relation to a thickness change of a capping layer.

Specifically, a hole transport-type organic material was coated on a silver (Ag) electrode having a thickness of 10 nm (100 Å) to form a capping layer. A transmittance change was measured while changing a thickness of the capping layer to obtain the graph shown in FIG. 28.

As shown in FIG. 28, a high transmittance region A may be defined in a thickness range less than about 70 nm (700 Å). For example, a maximum transmittance region may be defined within a range of about 35 nm (350 Å) to about 50 nm (500 Å). A low transmittance region B may be defined in a thickness range from about 70 nm (700 Å) to about 90 nm (900 Å).

Accordingly, a capping layer having a thickness within the low transmittance region B may be formed on a pixel area PA of a transparent display device, and a capping layer having a thickness within the high transmittance region A may be formed on a transmission area TA of the transparent display device. Therefore, the transparent display device having improved transmittance and display quality may be manufactured. For example, a capping layer having a thickness in a range from about 35 nm (350 Å) to about 70 nm (700 Å) may be formed on the transmission area TA in consideration of the transmittance in the transmission area TA, a protection of a lower structure under the capping layer, a consistency with the capping layer on the pixel area PA.

Additionally, the hole transport-type organic material was coated on a magnesium (Mg) electrode having a thickness of 10 nm (100 Å) to form a capping layer. A transmittance change was measured while changing a thickness of the capping layer to obtain the graph shown in FIG. 29.

Referring to FIG. 29, an overall transmittance obtained from the Mg electrode was reduced compared to that obtained from the Ag electrode. However, thicknesses of the capping layer corresponding to the high transmittance region A and the low transmittance region B were substantially the same as or similar to those measured in FIG. 28.

As discussed, embodiments of the invention can provide a transparent display device, comprising: a substrate having a pixel area and a transmission area; a pixel circuit in the pixel area of the substrate; an insulation structure covering the pixel circuit on the substrate; a first electrode in the pixel area of the substrate and extending at least partially through the insulation structure to be electrically connected to the pixel circuit; a display layer on the first electrode; a second electrode facing the first electrode with respect to the display layer; and a capping layer on the second electrode, the capping layer extending continuously into the pixel area and the transmission area, the capping layer having a thickness in a range from about 35 nm to about 70 nm.

Embodiments of the invention can also provide a transparent display device, comprising: a substrate having a pixel area and a transmission area; a pixel circuit at the pixel area of the substrate; an insulation structure covering the pixel circuit on the substrate; a first electrode at the pixel area of the substrate and extending at least partially through the insulation structure to be electrically connected to the pixel circuit; a display layer on the first electrode; a second electrode facing the first electrode with respect to the display layer; and a capping layer on the second electrode, the capping layer continuously extending into the pixel area and the transmission area, the capping layer having different thicknesses at the pixel area and the transmission area.

Embodiments of the invention can also provide a method of manufacturing a transparent display device, comprising: preparing a substrate having a pixel area and a transmission area; forming a pixel circuit on the substrate; forming an insulation structure on the substrate, the insulation structure at least partially covering the pixel circuit; forming a first electrode on a portion of the insulation structure at the pixel area, the first electrode being electrically connected to the pixel circuit; forming a display layer on the first electrode; forming a second electrode on the display layer, the second electrode facing the first electrode; determining a maximum transmittance thickness and a maximum luminescent efficiency thickness of a capping layer under a thickness condition of the second electrode; and forming the capping layer on the second electrode, the capping layer having the maximum luminescent efficiency thickness at the pixel area and the maximum transmittance thickness at the transmittance area. In such embodiments, the capping layer may include a first portion covering the pixel area and having a thickness in a range from about 70 nm to about 90 nm. The capping layer may include a second portion covering the transmission area and having a thickness in a range from about 35 nm to about 70 nm.

According to example embodiments of the present inventive concepts, a thickness of a capping layer may be adjusted depending on the material and the thickness of a second electrode serving as, e.g., a cathode of a transparent display device. Thus, the transparent display device having improved transmittance in a transmission area may be achieved. Further, the thickness of the capping layer may be differentiated at a pixel area to improve a luminescent efficiency in the pixel area.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept as defined in the claims. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A transparent display device, comprising:
a substrate having a pixel area and a transmission area;
a pixel circuit in the pixel area of the substrate;
an insulation structure covering the pixel circuit on the substrate;
a first electrode in the pixel area of the substrate and extending at least partially through the insulation structure to be electrically connected to the pixel circuit;
a display layer on the first electrode;
a second electrode facing the first electrode with respect to the display layer; and
a capping layer on the second electrode, the capping layer extending continuously into the pixel area and the transmission area, the capping layer having a thickness in a range from about 35 nm to about 70 nm.

2. The transparent display device of claim 1, wherein the second electrode continuously extends into the pixel area and the transmission area.

3. The transparent display device of claim 1 or 2, wherein the second electrode includes silver (Ag), magnesium (Mg), or an alloy of Ag and Mg; and/or
wherein the second electrode has a thickness in a range from about 3 nm to about 12 nm.

4. The transparent display device of any one of claims 1 to 3, wherein the display layer includes an organic light emitting layer,
the first electrode and the second electrode serve as an anode and a cathode, respectively, and
the capping layer includes a hole transport-type organic material.

5. The transparent display device of any one of claims 1 to 4, further comprising a pixel defining layer on the insulation structure,
wherein a transmitting window exposing the insulation structure at the transmission area is defined by a top surface of the insulation structure and a sidewall of the pixel defining layer.

6. The transparent display device of any one of claims 1 to 5, wherein the pixel circuit includes an active pattern, a gate electrode, a source electrode and a drain electrode on the substrate,
wherein the insulation structure includes:
a gate insulation layer covering the active pattern on the substrate;
an insulating interlayer covering the gate electrode on the gate insulation layer; and
a via insulation layer covering the source electrode and the drain electrode on the insulating interlayer,
wherein the source electrode and the drain electrode extend through the insulating interlayer and the gate insulation layer to be in contact with the active pattern, and the first electrode extends through the via insulation layer to be in contact with the drain electrode.

7. The transparent display device of claim 6, wherein the via insulation layer is selectively formed at the pixel area, and a transmitting window is defined at the transmission area by a sidewall of the via insulation layer and a top surface of the insulating interlayer;
optionally wherein the second electrode and the capping layer are formed along a surface of the transmitting window at the transmission area.

8. The transparent display device of claim 6, wherein the via insulation layer and the insulating interlayer are selectively disposed in the pixel area, and a transmitting window is defined at the transmission area by a sidewall of the via insulation layer and a top surface of the gate insulation layer.

9. The transparent display device of any one of claims 1 to 8, further comprising a filling layer and an encapsulation substrate sequentially disposed on the capping layer;
optionally wherein the capping layer includes an organic material having a refractive index of at least about 1.85; and/or wherein the filling layer includes an organic material having a refractive index in a range from about 1.4 to about 1.6.

10. A transparent display device, comprising:
a substrate having a pixel area and a transmission area;
a pixel circuit at the pixel area of the substrate;
an insulation structure covering the pixel circuit on the substrate;
a first electrode at the pixel area of the substrate and extending at least partially through the insulation structure to be electrically connected to the pixel circuit;
a display layer on the first electrode;
a second electrode facing the first electrode with respect to the display layer; and
a capping layer on the second electrode, the capping layer continuously extending into the pixel area and the transmission area, the capping layer having different thicknesses at the pixel area and the transmission area.

11. The transparent display device of claim 10, wherein the capping layer includes:
a first portion covering the pixel area and having a thickness in a range from about 70 nm to about 90 nm; and
a second portion covering the transmission area and having a thickness in a range from about 35 nm to about 70 nm.

12. The transparent display device of claim 10 or 11, wherein the second electrode continuously extends into the pixel area and the transmission area; and/or
wherein the second electrode includes Ag, Mg, or an alloy of Ag and Mg, and the second electrode has a thickness in a range from about 3 nm to about 12 nm.

13. The transparent display device of any one of claims 10 to 12, wherein a thickness of the insulation structure at the transmission area is less than a thickness of the insulation structure at the pixel area, and a transmitting window is defined by a surface of the insulation structure at the transmission area,
wherein the second electrode and the capping layer are formed along a surface of the transmitting window at the transmission area.

14. A method of manufacturing a transparent display device, comprising:
preparing a substrate having a pixel area and a transmission area;
forming a pixel circuit on the substrate;
forming an insulation structure on the substrate, the insulation structure at least partially covering the pixel circuit;
forming a first electrode on a portion of the insulation structure at the pixel area, the first electrode being electrically connected to the pixel circuit;
forming a display layer on the first electrode;
forming a second electrode on the display layer, the second electrode facing the first electrode;
determining a maximum transmittance thickness and a maximum luminescent efficiency thickness of a capping layer under a thickness condition of the second electrode; and
forming the capping layer on the second electrode, the capping layer having the maximum luminescent efficiency thickness at the pixel area and the maximum transmittance thickness at the transmittance area.

15. The method of claim 14, wherein the maximum luminescent efficiency thickness corresponds to a minimum transmittance thickness.
